Europäisches Patentamt

**European Patent Office**

**Office européen des brevets**

(19)

(11) Numéro de publication: **0 168 312**
**B1**

(12) **FASCICULE DE BREVET EUROPEEN**

(45) Date de publication du fascicule du brevet:
**28.12.88**

(51) Int. Cl.⁴: **H 01 L 43/14,** H 01 L 21/324

(21) Numéro de dépôt: **85401285.3**

(22) Date de dépôt: **25.06.85**

(54) **Procédé de fabrication de capteurs à effet Hall en couches minces.**

(30) Priorité: **29.06.84 FR 8410363**

(43) Date de publication de la demande:
**15.01.86 Bulletin 86/3**

(45) Mention de la délivrance du brevet:
**28.12.88 Bulletin 88/52**

(84) Etats contractants désignés:
**DE GB IT NL**

(56) Documents cités:
**WO-A-82/03639**

**PATENTS ABSTRACTS OF JAPAN, vol. 4, no. 181
(E-37)[663], 13 décembre 1980**

(73) Titulaire: **COMMISSARIAT A L'ENERGIE ATOMIQUE,
31/33, rue de la Fédération, F-75015 Paris (FR)**

(72) Inventeur: **Chapuy, Claude, Saint Quentin sur Isère,
F-38210 Tullins (FR)**
Inventeur: **Delapierre, Gilles, 7, rue des Laboureurs,
F-38170 Seyssins (FR)**

(74) Mandataire: **Mongrédien, André et al, c/o
BREVATOME 25, rue de Ponthieu, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

L'invention se rapporte à un procédé de fabrication de capteurs à effet Hall en couches minces.

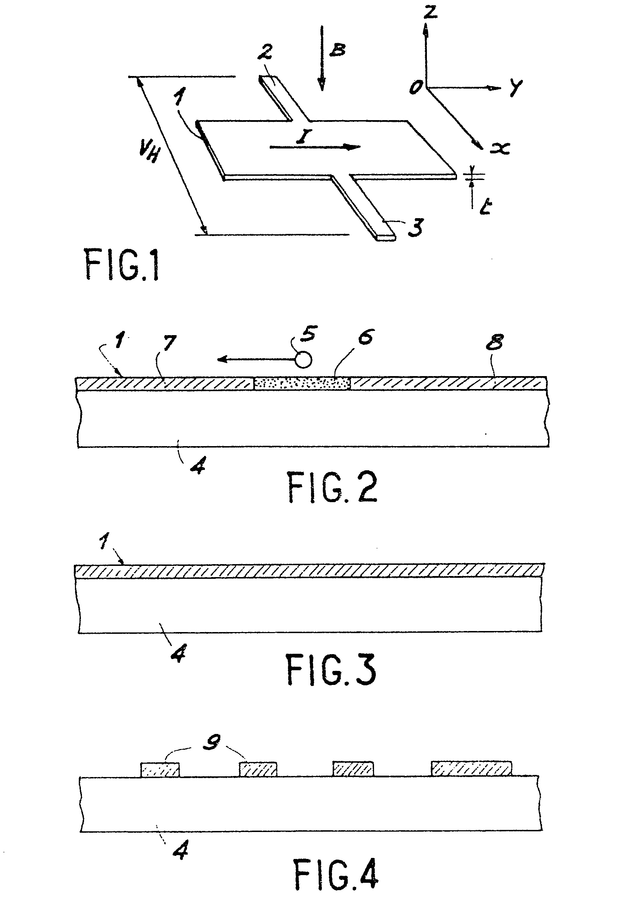

L'effet Hall est un principe physique connu et très utilisé pour la mesure des champs magnétiques, dont on rappellera l'essentiel en se référant à la figure 1. Un corps semiconducteur 1 est placé dans une induction $\vec{B}$ et parcouru par un courant I ($\vec{I}$ et $\vec{B}$ perpendiculaires).

On appelle tension de Hall la tension VH qui apparaît entre les côtés 2 et 3 parallèles au courant I qui circule dans le semiconducteur 1 lorsque celui-ci est soumis à l'induction magnétique $\vec{B}$ perpendiculaire. Elle est due à la déviation par l'induction magnétique $\vec{B}$ des électrons en mouvement dans le semiconducteur 1.

La loi reliant les différentes grandeurs s'écrit:

$$VHx = \frac{Iy \cdot Bz}{n \cdot e \cdot t} \qquad (1)$$

où n est le nombre d'électrons de conduction par centimètre cube, t l'épaisseur du matériau et e la charge de l'électron.

Cette équation (1) permet donc de déterminer l'induction Bz à une constante de proportionnalité près, si l'on connaît Iy et VHx.

Pour avoir une bonne sensibilité, on cherche donc à avoir un matériau semiconducteur avec une densité de porteur n et une épaisseur t les plus faibles possibles.

D'après la relation (1) ci-dessus, on pourrait croire que pour augmenter VH il suffit d'augmenter le courant de polarisation I. Malheureusement, il existe une limite pratique à cet accroissement de I, du fait de l'élévation de la température qui en résulte.

Pour repousser cette limite, il est nécessaire d'avoir un semiconducteur ayant une bonne conductivité électrique.

Comme cette conductivité électrique s'exprime par la relation (2):

$$\sigma = e \cdot n \cdot \mu_n \qquad (2)$$

relation dans laquelle $\mu_n$ est la mobilité des charges négatives, on voit que pour avoir une bonne conductivité, il sera nécessaire d'utiliser un semiconducteur dont la mobilité des porteurs $\mu_n$ soit la plus grande possible.

Les semiconduteurs répondant le mieux à ce critère sont InSb avec $\mu_n n = 78000$ cm²/Vs et InAs avec 33.000 cm²/Vs. A titre de comparaison on a pour GaAs $\mu_n n = 8500$, pour InP $\mu_n n = 4600$, pour Ge $\mu_n = 3900$, pour Si $\mu_n = 1900$.

On a donc recours de préférence à InSb qui, outre la plus forte mobilité, possède le plus bas point de fusion (Tf = 525 °C).

Un autre critère devenu important de nos jours lorsque l'on développe une nouvelle technologie de fabrication de capteurs, est son aptitude à permettre une fabrication collective et donc économique de grandes quantités de capteurs de petite dimension.

En résumé les principales qualités que l'on demande à une telle technologie résident dans ses possibilités:

1) d'utiliser un matériau à forte mobilité des porteurs $\mu_n$;

2) de permettre une épaisseur t de semiconducteur la plus faible possible;

3) de permettre la réalisation de capteurs de très petite dimension (quelques microns);

4) de conduire à une fabrication simultanée d'un très grand nombre de capteurs.

La technologie la plus ancienne et la plus utilisée actuellement pour réaliser des détecteurs à effet hall consiste à prendre des lingots de monocristaux de InSb ou In As, à les découper en tranches, à coller ces tranches sur un substrat, à amincir ces tranches par polissage, puis à graver le matériau pour avoir la forme voulue des capteurs.

Avec ce procédé, la condition 1 est très bien satisfaite puisque l'on peut utiliser un monocristal presque parfait; on peut satisfaire en partie la condition 4; en revanche des conditions 2 et 3 sont très mal assurées, car ce n'est qu'au prix de grandes précautions que l'on arrive à des épaisseurs de l'ordre de 10 μm, ce qui reste malgré tout une valeur élevée. Outre une perte en sensibilité, cette forte épaisseur limite la finesse des gravures et donc les dimensions de capteur que l'on peut réaliser (plusieurs dizaines de microns) alors que beaucoup d'applications demandent des capteurs de l'ordre du micron.

Face à cette difficulté, de nombreux laboratoires ont pensé à utiliser la technologie des couches minces pour déposer le semiconducteur directement sur le substrat. Dans ce cas, il devient en effet facile de réaliser les conditions 2, 3 et 4 puisqu'il est plutôt plus aisé de déposer une couche d'une fraction de micron d'épaisseur qu'une couche épaisse.

Malheureusement, dans ce cas la condition 1 est très mal satisfaite. Le matériau obtenu par dépôt sous vide est en effet polycristallin, c'est-à-dire constitué d'une multitude de très petits cristaux qui limitent considérablement la mobilité des électrons. La mobilité est généralement inférieure à 1000 cm²/Vs pour InSb. Elle peut atteindre exceptionnellement 10 000 cm²/Vs moyennant des conditions de dépôt très difficiles à contrôler et ceci avec de toute façon une très mauvaise reproductibilité.

Pour améliorer cette situation, de nombreux laboratoires ont envisagé de recristalliser le semiconducteur directement sur le substrat, en refondant le matériau après dépôt, de façon à obtenir une taille de grains plus importante lors de la solidification.

Le résultat le plus intéressant publié dans ce domaine est probablement celui de AR Clawson, 1972 dans «Thin solid Film» n°12 page 291.

Cet auteur a imaginé une méthode de recristallisation que l'on peut appeler «méthode du fil chaud». Une mobilité voisine de celle du monocristal a en effet pu être obtenue. Cette méthode, schématisée sur la figure 2, consiste à placer au voisinage de la couche mince 1 déposé sur le substrat 4 un fil résistif tendu 5, à faire fondre la couche 1 sur une largeur étroite 6 (~1 mm) en faisant passer un courant électrique dans le fil 5, et à déplacer cette zone fondue 6 en déplaçant le fil 5 devant le substrat 1. La zone fondue 6 sépare ainsi la partie polycristalline 7 de la partie recristallisée 8 du semiconducteur 1.

Depuis cette publication, la méthode a été reprise par de nombreux laboratoires pratiquement sans modification. On trouvera un bon exemple de tentatives d'applications dans les publications de:

- Tetsu Oi et al. Japanese Journal of applied Physics vol 17 n°2 Feb 1978, pp407–412
- Nobuo Kotera et al. IEEE trans on magnetics vol MAG15 n°6 Nov 1979.

Bien que très intéressante, cette méthode présente encore un certain nombre de défauts qui peuvent expliquer qu'elle n'ait pas encore dépassé le stade du laboratoire.

Les principales difficultés rencontrées dans la pratique viennent du fait qu'après recristallisation on constate de très grandes variations dans l'épaisseur de la couche. Ces irrégularités peuvent aller jusqu'à des trous en certains endroits, ce qui apparaît assez bien dans les deux publications citées précédemment.

Cet inconvénient est extrêmement gênant lorsque l'on aborde les applications réelles car, outre le fait qu'il ne permet pas de réaliser des dispositifs aux propriétés et géométries bien contrôlées, il interdit pratiquement toute opération de microlithographie précise et donc la réalisation de capteurs de petites dimensions.

Ceci explique notamment que les auteurs cités aient été obligés de recourir à un procédé des plus délicats, de polissage après recristallisation, ce qui enlève pratiquement tout intérêt à la technologie des couches minces.

Un autre inconvénient de la méthode du fil chauffant, est qu'il peut conduire à de très fortes contraintes thermiques dans le substrat. Dans certains cas (détecteur sur grenat pour mémoires à bulles par exemple) ceci est suffisant pour casser le substrat et pour interdire toute utilisation.

Une autre difficulté, moins sérieuse mais tout de même réelle de cette méthode est que la conductivité thermique entre fil et substrat doit être bien contrôlée, ce qui oblige à travailler sous hélium et alourdit donc le procédé de fabrication.

La présente invention a précisément pour objet un procédé de fabrication de capteurs à effet Hall en couches minces, qui permet, tout en étant une méthode de recristallisation après dépôt, de résoudre de façon particulièrement simple et efficace l'ensemble des problèmes précédemment rappelés de l'art antérieur.

Ce procédé de fabrication de capteurs à effet Hall en couches minces du genre de ceux qui comprennent des éléments de semiconducteurs déposés sous vide en couches minces sur un substrat et recristallisés in situ après dépôt par une nouvelle fusion du matériau semiconducteur, se caractérise par la succession des étapes suivantes:

- après dépôt sous vide de la couche mince de semiconducteur sur le substrat, on découpe dans cette couche les éléments actifs du capteur par tout moyen connu tel que gravure chimique ou bombardement ionique, de façon à réaliser ces éléments actifs sous forme de bandes étroites, notamment de largeur inférieure à 20 μm;
- on recouvre ensuite l'ensemble précédement obtenu d'une couche isolante de SiO$_2$;
- on recouvre la couche précédente d'une couche métallique conductrice, d'une épaisseur de l'ordre de 100 nm (1000Å), en un matériau, tel que NiCr ou W, résistant bien à la température;
- on grave cette couche métallique de façon à réaliser des résistances chauffantes localisées audessus des bandes étroites de semiconducteur précédentes;
- on fait passer un courant électrique dans les résistances chauffantes précédentes de façon à obtenir par effet Joule l'échauffement puis la fusion et la recristallisation des bandes étroites de semiconducteur;
- on enlève par attaques chimiques successives la couche métallique des résistances chauffantes puis la couche de SiO$_2$ sur les zones non recristallisées du semiconducteur;
- on dépose et on grave une couche conductrice dans les trous de SiO$_2$ pour les prises de contact d'alimentation du capteur en courant de polarisation et de prélèvement de la tension de Hall.

Comme dans les procédés antérieurs, le dépôt sous vide de la couche semiconductrice sur un substrat peut être réalisé par évaporation sous vide. On peut néanmoins utiliser avantageusement la pulvérisation cathodique de façon à obtenir un matériau homogène et par conséquent apte à des opérations de microlithographie ultérieures précises.

L'une des caractéristiques essentielles du procédé précédent réside dans le fait que la forme choisie pour les parties actives des capteurs, que l'on réalise par gravure chimique ou par bombardement ionique, consiste en une mise en parallèle ou en série de bandes étroites allongées, typiquement d'une largeur inférieure à 20 μm. Le fait de dessiner ainsi un capteur dont les zones actives sont constituées d'éléments étroits, apporte deux avantages fondamentaux: d'abord il permet d'avoir un courant de chauffage dans les résistances chauffantes localisées de valeur raisonnable, c'est-à-dire relativement faible; ensuite il permet d'éviter lors des opérations de recristallisation des bandes étroites de semiconducteur un manque d'uniformité d'épaisseur car, sur une largeur aussi courte, le semiconducteur liquide n'a pas la possibilité de former des vagues qui seraient ensuite figées lors de la solidification.

Un autre avantage important du procédé selon l'invention découle du fait que la couche métallique conductrice qui recouvre les zones à recristalliser est bien localisée et permet d'obtenir le chauffage de cette dernière zone et uniquement de cette zone de façon très précise.

Enfin, les différentes étapes de fabrication du procédé objet de l'invention permettent sans difficulté la réalisation simultanée d'un grand nombre de capteurs microscopiques à effet Hall, à partir d'une même couche de semiconducteurs déposés sur un substrat. Ceci est un avantage non négligeable du présent procédé par rapport à la méthode du fil chauffant mobile précédemment utilisée.

Selon une variante améliorée du procédé de fabrication précédent, on réalise la gravure des résistances chauffantes de façon légèrement décentrée par rapport à l'axe longitudinal de la partie de la bande étroite de semiconducteur utilisée dans le capteur. En d'autres termes, on s'arrange ainsi pour que lors de la solidification d'une zone fondue pour obtenir sa recristallisation, les deux fronts de solidification qui sont symétriques par rapport à la résistance, et qui se rapprochent symétriquement l'un de l'autre lors du refroidissement, viennent se rencontrer selon une ligne légèrement décentrée de quelques micromètres par exemple par rapport au centre de la bande active future du capteur à effet Hall. De cette façon, il se produit un entraînement par effet de fusion de zone des impuretés éventuellement contenues dans le semiconducteur vers l'un des bords latéraux de la bande active, ce qui supprime l'effet néfaste de ces impuretés en permettant une amélioration sensible du rapport $1/ne$ dans lequel n est le nombre d'électrons de conduction par $cm^3$ du semiconducteur et e la charge élémentaire de chaque électron. A ce sujet, on peut noter qu'il n'est pas nécessaire d'avoir une bonne pureté sur toute la surface de chaque bande et que l'on obtient une bonne sensibilité si la longueur de bande sur laquelle la purification est ainsi obtenue est de l'ordre de 3 fois la largeur de chaque bande.

De toute façon l'invention sera mieux comprise en se référant à la description qui suit de plusieurs modes de mise en oeuvre du procédé de fabrication de capteurs à effet Hall, description qui sera faite en se référant aux figures 3 à 10 sur lesquelles:

Les Figures 3, 4 montrent les deux premières étapes de réalisation des capteurs à effet Hall selon l'invention.

Les figures 5 et 6 montrent deux formes particulières de découpage des capteurs fabriqués selon le procédé de l'invention.

Les figures 7, 8 et 9 (9a vue de dessus, 9b vue en coupe selon AA de la figure 9a) montrent les étapes finales du procédé de fabrication objet de l'invention.

La figure 10 montre la variante du procédé de fabrication du capteur à effet Hall objet de l'invention dans laquelle on procède à une purification par fusion de zone de la partie recristallisée du semiconducteur, la partie inférieure de la figure 10 montre la répartition des températures autour de l'axe de la résistance chauffante.

Sur la figure 3, on a représenté la première étape du procédé de fabrication objet de l'invention qui comporte le dépôt sur un substrat 4, par exemple en verre ou en céramique, d'une couche 1 semiconductrice en antimoniure d'indium InSb. Ce dépôt peut être fait par tout moyen connu, tel que l'évaporation sous vide ou de préférence la pulvérisation cathodique qui donne un matériau beaucoup plus homogène et donc facilite les opérations de microlithographie précise ultérieure.

Sur la figure 4 on a montré l'étape suivante qui est une délimitation par découpage en un certain nombre de bandes telles que 9 de la couche semiconductrice 1 précédente aux fins d'obtenir des éléments actifs sous forme de bandes étroites, de préférence de largeur inférieure à 20 μm. Ce découpage est obtenu également par tout moyen connu tel que la gravure chimique à l'aide d'un masque ou le bombardement ionique permettant d'enlever le matériau semiconducteur avec une grande précision aux endroits voulus.

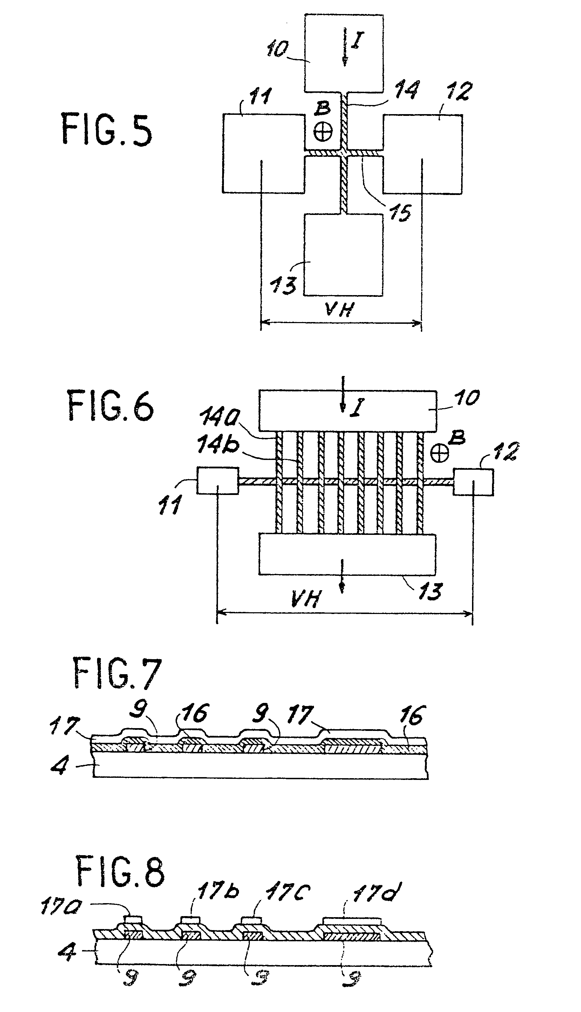

Selon l'invention, il est préférable de dessiner le capteur de telle façon que les parties actives qui interviennent dans la génération de la tension de Hall soient constituées d'un certain nombre de bandes ou éléments étroits mis en parallèle ou en série comme on le représente sur les figures 5 et 6 qui donnent deux exemples possibles de mise en oeuvre.

Sur la figure 5, le capteur représenté comporte quatre zones de contact 10, 11, 12 et 13 qui n'ont pas subi la recristallisation et deux bandes actives 14 et 15 à angle droit qui sont destinées à subir une recristallisation pour posséder une mobilité des charges négatives élevée. Les électrodes 10 et 13 servent à la circulation du courant de polarisation I dans la bande conductrice 14 et les électrodes 11 et 12 servent au prélèvement de la tension de Hall Vh.

Dans une version plus compliquée du capteur objet de l'invention représenté figure 6, on découpe la zone active parcourue par le courant de polarisation I en une série de bandes étroites 14a, 14b, 14c, etc.... en parallèle et on retrouve les électrodes 10, 11, 12 et 13 de la figure 5 précédente. Le fait d'avoir plusieurs bandes étroites en parallèle 14a, b, c, d, etc... permet de faire passer dans le capteur un courant de polarisation plus important et par conséquent d'augmenter la tension Vh de Hall recueillie aux bornes de l'ensemble.

L'étape suivante (figure 7) consiste dans le dépôt d'une couche isolante de silice $SiO_2$ sur la structure obtenue figure 4. Cette couche 16 a une épaisseur de l'ordre de 1 μm par exemple.

L'étape ultérieure du procédé objet de l'invention consiste à recouvrir la couche de silice 16 d'une couche métallique conductrice et résistive 17 d'une épaisseur de l'ordre de 100 μm (1000 Å). Cette couche 17 est constituée le plus souvent, soit en alliage nickel-chrome NiCr, soit en tungstène W.

Après le dépôt de cette couche métallique, on la grave de façon à constituer un certain nombre de résistances chauffantes 17a, 17b, 17c et 17d visibles sur la figure 8, dont chacune est située au droit des bandes 9 de matériau semiconducteur destiné à être recristallisé. Ces différentes résistances chauffantes sont découpées à l'aide d'un masque qui peut être notamment le même que celui qui a servi à la gravure des bandes de semiconducteurs 9.

Une fois la structure de la figure 8 obtenue, on provoque par le passage d'un courant dans les résistancs chauffantes 17 la fusion de l'antimoniure d'indium InSb, l'injection de courant pouvant se faire par exemple à l'aide de pointes.

C'est à ce stade que l'on tire avantage d'avoir constitué les parties actives du capteur sous forme de bandes étroites. En effet, cette structure permet d'utiliser un courant de chauffage relativement faible donc de valeur raisonnable et on évite ainsi le manque d'uniformité d'épaisseur de la couche d'antimoniure d'indium car, sur une largeur aussi courte, la phase liquide n'a pas la possibilité de former des vagues qui pourraient être ensuite figées lors de la solidification.

Dans une étape ultérieure du procédé objet de l'invention, on enlève d'abord les résistances chauffantes 17 et ensuite la couche de $SiO_2$ sur les zones non recristallisées. Les résistances chauffantes 17 sont enlevées à l'aide d'une solution contenant $SO_4H_2$ à 25% et à 60 °C en solution commerciale «CHROME-ETCH» bien connue. La silice $SiO_2$ est attaquée chimiquement, par exemple à l'aide d'acide fluorhydrique.

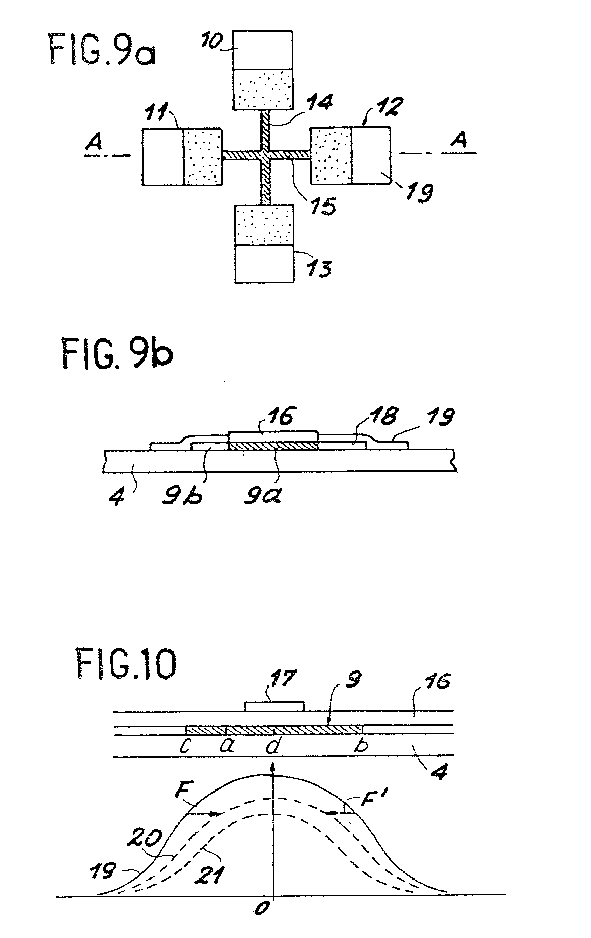

A ce moment intervient la dernière opération qui consiste à graver une couche conductrice (par exemple un alliage de chrome et d'or CrAu ou du cuivre Cu) dans les trous de silice pour obtenir les prises de contact nécessaires à l'exploitation électrique du capteur. A la fin de l'opération, on obtient par exemple un capteur tel que visible sur les figures 9a, (vue de dessus) et 9b (vue en coupe) sur lesquelles on a représenté les bandes conductrices 14 et 15 en antimoniure d'indium recristallisé couvertes de silice $SiO_2$ et les quatre électrodes de contact 10, 11, 12, 13 disposées sur des zones où le semiconducteur n'a pas été recristallisé. La couche conductrice de cuivre ou d'alliage chrome-or est représentée en 18; la couche de semiconducteur InSb comporte des parties 9a qui ont été recristallisées lors des opérations de fusion précédentes à l'aide des résistances chauffantes locales 17 et des parties 9b non recristallisées. La couche conductrice 18 permet le branchement des connexions 19 reliant le capteur à l'extérieur.

Dans le procédé de fabrication objet de l'invention que l'on vient de décrire, on se contente pour accroître la mobilité μn des porteurs de charges négatives dans le semiconducteur, d'effectuer une recristallisation provoquant un accroissement de la taille des grains. Cette façon de procéder permet d'obtenir un rapport 1/ne voisin de 100 cm³ par coulomb dans le cas de l'emploi d'InSb comme semiconducteur, ce qui est tout à fait acceptable.

Si l'on désire néanmoins améliorer encore cette performance en provoquant en outre une purification du semiconducteur par diminution du nombre d'impuretés qu'il contient, ce qui augmente la valeur du paramètre n, on peut y parvenir en ayant recours à une variante du procédé décrite sur la figure 10. Dans cette variante, on déplace légèrement les résistances chauffantes 17 de quelques micromètres par rapport à l'axe de la partie active a, b, des bandes conductrices de semiconducteur 9 de façon à ce que lors de la solidification de la zone fondue 9, les avancées des fronts de solidification c, b, les fassent se rencontrer en un point d où seront concentrées les impuretés qui auront été déplacées par fusion de zone; le point d est déporté par rapport au centre de la bande active a, b, effectivement utilisée pour l'effet Hall. Les impuretés ainsi rassemblées autour de d n'ont pas d'influence sur le fonctionnement du capteur car elles se situent en marge du centre actif de la bande de semiconducteur correspondante. Pour mieux faire comprendre le phénomène, ceci a été représenté de façon très exagérée sur la figure 10, où l'on retrouve les éléments des figures antérieures portant les mêmes nombres de références. Ces limites b, c, représentent la zone fondue de semiconducteur centrée sur la résistance 17 et a, b, la seule partie active ultérieurement utilisée de la bande de semiconducteur dans le capteur proprement dit.

A la partie inférieure du dessin on a représenté les courbes de refroidissement 19, 20 et 21 montrant les températures dans la zone fondue 9 en fonction de la distance à l'axe de la résistance 17. La courbe 19 montre la température maximale obtenue au moment de la fusion; la courbe 21 correspond au cas où cette température maximale est la température de fusion c'est-à-dire à l'époque ou les fronts de solidification c et b se rencontrent. Entre les deux, la courbe 20 illustre le cas d'une température intermédiaire au centre de la zone fondue et les flèches F et F' dessinées permettent de connaître, pour cette température de refroidissement et à cette époque, la position des fronts de solidification.

Le procédé objet de l'invention qui vient d'être décrit a le grand avantage de ne nécessiter aucune opération mécanique et de pouvoir être réalisé à l'air libre avec les équipements classiques de la microélectronique. Il permet la fabrication de capteurs à effet Hall ayant un bon rendement grâce à une forte mobilité des charges négatives là où c'est utile et ayant des dimensions et des épaisseurs aussi petites que souhaitées avec les avantages d'une fabrication collective sur n'importe quel substrat même fragile. Il ne nécessite de plus qu'un apport d'énergie totale très faible lors de l'étape de recristallisation.

## Revendication

1. Procédé de fabrication de capteurs à effet Hall en couches minces, du genre de ceux qui comprennent des éléments de semiconducteurs déposés sous vide en couches minces sur un substrat et recristallisés in situ après dépôt par une nouvelle fusion du matériau semiconducteur, caractérisé par la successsion des étapes suivantes:
- après dépôt sous vide de la couche mince (1) de semiconducteur sur le substrat (4), on découpe dans cette couche les éléments actifs (9) du capteur par tout moyen connu tel que gravure chimique ou bombardement ionique, de façon à réaliser ces éléments actifs sous forme de bandes étroites, (14, 15) notamment de largeur inférieure à 20 µm;
- on recouvre ensuite l'ensemble précédemment obtenu d'une couche isolante de SiO₂ (16);
- on recouvre la couche précédente d'une couche métallique conductrice (17) d'une épaisseur de l'ordre de 100 nm, en un matériau, tel que NiCr ou W, résistant bien à la température,
- on grave cette couche métallique (17) de façon à réaliser des résistances chauffantes (17a...17d) localisées au-dessus des bandes étroites de semiconducteur précédentes;
- on fait passer un courant électrique dans les résistances chauffantes précédentes de façon à obtenir par effet Joule l'échauffement puis la fusion et la recristallisation des bandes étroites (14, 15) de semiconducteur;
- on enlève par attaques chimiques successives la couche métallique des résistances chauffantes (17) puis la couche de SiO₂ (16) sur les zones non recristallisées du semiconducteur;
- on dépose et on grave une couche conductrice (18) dans les trous de SiO₂ pour les prises de contact d'alimentation (19) du capteur en courant de polarisation et de prélèvement de la tension de Hall.

2. Procédé de fabrication de capteurs à effet Hall selon la revendication 1, caractérisé en ce que l'on réalise les résistances chauffantes (17) de façon légèrement décentrée, typiquement de quelques µm, par rapport à l'axe longitudinal de la partie active de la bande étroite (9) de semiconducteur utilisée dans le capteur, de façon à provoquer par fusion de zone lors de l'avancée du front de solidification de la zone fondue, un entraînement des impuretés en dehors de cette partie active du capteur.

3. Procédé selon l'une quelconque des revendications 1 et 2, caractérisé en ce que le semiconducteur utilisé est l'antimoniure d'indium InSb et la couche métallique résistive est choisie parmi le tungstène W et l'alliage nickel-chrome NiCr.

## Patentansprüche

1. Verfahren zum Herstellen von Halleffektsensoren in Dünnschichten, bei welchem Halbleiterelemente in Form dünner Schichten im Vakuum auf einem Substrat deponiert und nach dem Deponieren durch erneute Verschmelzung des Halbleitermaterials an Ort und Stelle rekristallisiert werden, gekennzeichnet durch die nachstehend genannte Folge von Schritten:
- nach Deponieren der Halbleiter-Dünnschicht (1) im Vakuum auf dem Substrat (4) werden unter Verwendung bekannter Mittel, z.B. chemisches Ätzen oder Ionenbeschuss, die aktiven Elemente (9) des Sensors derart aus der Dünnschicht ausgeschnitten, dass die aktiven Elemente in Form von schmalen Stegen (14, 15) insbesondere mit einer Breite von weniger als 20 µm ausgebildet werden,
- die wie vorstehend erhaltene Anordnung wird mit einer Isolierschicht (16) aus SiO₂ überdeckt,
- die vorstehend genannte Schicht wird mit einer metallischen Leiterschicht (17) mit einer Dicke in der Grössenordnung von 100 nm aus einem gut temperaturbeständigen Material, z.B. NiCr oder W, überzogen,
- die metallische Schicht (17) wird derart geätzt, dass sich über den genannten schmalen Halbleiterstegen einzelne Heizwiderstände (17a ... 17d) ausbilden,
- durch die genannten Heizwiderstände wird ein elektrischer Strom geleitet, um durch den Joule'schen Effekt die Erhitzung und darauf das Schmelzen und die Rekristallisation der schmalen Halbleiterstege (14, 15) herbeizuführen,
- durch aufeinander folgend chemische Behandlungen werden die metallische Schicht der Heizwiderstände (17) und danach die SiO₂-Schicht (16) von den nicht rekristallisierten Bereichen des Halbleiters entfernt,
- und in den von SiO₂ freien Bereichen werden durch Deponieren und Ätzen einer Leiterschicht (18) Kontaktstellen (19) für die Speisung des Sensors mit Polarisationsstrom und für die Abnahme der Hall-Spannung ausgebildet.

2. Verfahren für die Herstellung von Halleffektsensoren nach Anspruch 1, dadurch gekennzeichnet, dass man die Heizwiderstände (17) in bezug auf die Längsachse des im Sensor genutzten aktiven Bereichs des schmalen Halbleiterstegs (9) leicht versetzt, insbesondere um einige µm versetzt ausbildet, um beim Vordringen der Erstarrungsfront des geschmolzenen Bereichs durch Verschmelzung des Bereichs eine Mitnahme von Verunreinigungen aus dem aktiven Bereich des Sensors herbeizuführen.

3. Verfahren nach einem der Ansprüche 1 und 2, dadurch gekennzeichnet, dass der verwendete Halbleiter eine Antimon-Indiumlegierung InSb ist und dass die metallische Widerstandsschicht wahlweise aus Wolfram W oder einer Chrom-Nickellegierung NiCr ist.

## Claims

1. Process for the production of thin film Hall effect transducers of the type comprising semiconductor elements deposited on vacuo in thin film from, on a substrate and recrystallized in situ following deposition by a new melting of the semiconductor material, characterized in that it comprises the following stages:

- following vacuum deposition of the thin semiconductor film (1) on the substrate (4), the active elements (9) of the transducer are cut from said film by any known means, such as chemical etching or ionic bombardment, so as to produce these active elements in the form of narrow strips (14, 15), particularly having a width less than 20 μm;

- the previously obtained assembly is then covered with an insulating SiO₂ coating (16);

- the said coating is covered with a conductive metal coating (17) with a thickness of approximately 100 nm and from a material such as NiCr or W, which has a good heat resistance;

- said metal coating (17) is etched so as to form local heating resistors (17a...17d) above narrow semiconductor strips;

- passing an electric current into said heating resistors so as to obtain by the Joule effect the heating and then the melting and recrystallization of the thin semiconductor strips (14, 15);

- by successive chemical etching operations, the metallic coating of the heating resistors (17) and then the SiO₂ coating (16) is removed from the non-recrystallized zones of the semiconductor; and

- a conductive coating (18) is deposited and etched in the SiO₂ holes for the contact points (19) for supplying the transducer with polarizing current and for sampling the Hall voltage.

2. Process for the production of Hall effect transducers according to claim 1, characterized in that the heating resistors (17) are produced in a slightly offset manner, typically by a few μm, with respect to the longitudinal axis of the active part of the narrow semiconductor strip (9) used in the transducer, so as to bring about an entrainment of the impurities outside said active part of the transducer, the zone melting during the advance of the solidification front of the molten zone.

3. Process according to either of the claims 1 and 2, characterized in that the semiconductor used is indium antimony InSb and the resistive metallic coating is chosen from tungsten W and nickel–chrome alloy NiCr.

FIG.1

FIG.2

FIG.3

FIG.4

**FIG.5**

**FIG.6**

**FIG.7**

**FIG.8**

11

# FIG. 9a

# FIG. 9b

# FIG.10